# EUROPÄISCHE PATENTSCHRIFT

(11) **EP 0 797 792 B1**
(45) Veröffentlichungstag und Bekanntmachung des Hinweises auf die Patenterteilung: **18.11.1998**
(21) Anmeldenummer: 95929737.5
(22) Anmeldetag: 01.09.1995
(51) Int. Cl.: G03F 7/38, G03F 7/022

(54) **PHOTOLITHOGRAPHISCHE STRUKTURERZEUGUNG**
PHOTOLITHOGRAPHIC METHOD OF PRODUCING STRUCTURAL FEATURES
PRODUCTION DE STRUCTURES PAR PHOTOLITHOGRAPHIE

(30) Priorität: 12.09.1994 DE 4432446
(43) Veröffentlichungstag der Anmeldung: 01.10.1997
(73) Patentinhaber: SIEMENS AKTIENGESELLSCHAFT, 80333 München (DE)
(72) Erfinder: SEZI, Recai, D-91341 Röttenbach (DE); LEUSCHNER, Rainer, D-91056 Erlangen (DE); SCHMIDT, Erwin, D-91058 Erlangen (DE)
(86) Internationale Anmeldenummer: DE9501184
(87) Internationale Veröffentlichungsnummer: WO9608750

(56) Entgegenhaltungen:
- EP-A- 0 351 849
- EP-A- 0 369 219
- WO-A-94/02885
- US-A- 5 314 782
- PRZYBILLA K J ET AL 'Delay time stable chemically amplified deep UV resist' , ADVANCES IN RESIST TECHNOLOGY AND PROCESSING X, SAN JOSE, CA, USA, 1-2 MARCH 1993 , ISSN 0277-786X, PROCEEDINGS OF THE SPIE - THE INTERNATIONAL SOCIETY FOR OPTICAL ENGINEERING, 1993, USA, PAGE(S) 76 - 91
- SCHWALM R ET AL 'A robust and environmentally stable deep UV positive resist: optimisation of SUCCESS ST2' , ADVANCES IN RESIST TECHNOLOGY AND PROCESSING XI, SAN JOSE, CA, USA, 28 FEB.-1 MARCH 1994 , ISSN 0277-786X, PROCEEDINGS OF THE SPIE - THE INTERNATIONAL SOCIETY FOR OPTICAL ENGINEERING, 1994, USA, PAGE(S) 2 - 13
- JAGANNATHAN P ET AL 'Environmentally stable chemically amplified DUV resist based on diazoketone chemistry' , ADVANCES IN RESIST TECHNOLOGY AND PROCESSING XI, SAN JOSE, CA, USA, 28 FEB.-1 MARCH 1994 , ISSN 0277-786X, PROCEEDINGS OF THE SPIE - THE INTERNATIONAL SOCIETY FOR OPTICAL ENGINEERING, 1994, USA, PAGE(S) 28 - 36
- DATABASE WPI Section Ch, Week 9303 Derwent Publications Ltd., London, GB; Class A89, AN 93-021675 & JP-A-04 347 857 ( TOSHIBA KK) , 3.Dezember 1992

## Beschreibung

Die Erfindung betrifft ein Verfahren zur photolithographischen Strukturerzeugung - mittels eines trockenentwickelbaren Einlagenresistsystems - im Submikron-Bereich.

In der Mikroelektronik werden in großem Umfang sogenannte chemisch verstärkte Resists ("chemically amplified resists") eingesetzt (siehe dazu: "Solid State Technology", Vol. 34 (1991), No. 8, Seiten 53 bis 60). Die chemische Verstärkung findet sowohl bei naßentwickelbaren Einlagenresists Anwendung als auch bei ganz oder teilweise trockenentwickelbaren Resists. Die Resists können dabei nach dem Prinzip der saurekatalytischen Spaltung arbeiten, wobei polare, aber blockierte chemische Gruppen, beispielsweise Carboxylgruppen oder phenolische Hydroxylgruppen, durch eine photolytisch erzeugte Säure deblockiert werden und der Resist in den belichteten Bereichen seine Polarität ändert. Diese Polaritätsänderung kann beispielsweise bei trockenentwickelbaren Resists für eine selektive Silylierung genutzt werden. Beispiele für blockierende Gruppen sind tert.-Butylester- und tert.-Butoxycarbonyloxygruppen.

Aus der EP-OS 0 492 256 ist eine photolithographische Strukturerzeugung bekannt, bei der ein trockenentwickelbarer Resist nach der Belichtung einer Temperaturbehandlung (Post Exposure Bake = PEB) unterworfen, dann aus flüssiger Phase silyliert und anschließend im Sauerstoffplasma anisotrop geätzt wird. Je nach der Art der Silylierungslösung werden dabei positive oder negative Strukturen erzeugt. Der Resist besteht im allgemeinen mindestens aus zwei festen Bestandteilen, d.h. aus einem Basispolymer und einem photoaktiven Säurebildner. Das Basispolymer enthält Carbonsäureanhydrid- und tert.-Butylester-Partialstrukturen, der Säurebildner ist vorzugsweise eine Oniumverbindung, wie Diphenyljodonium- und Triphenylsulfonium-trifluormethansulfonat. Ein derartiger Resist eignet sich insbesondere für die Photostrukturierung im Submikron- und Subhalbmikron-Bereich mit sehr steilen Flanken.

Bei einer Strukturerzeugung in der vorstehend geschilderten Weise wurde - ebenso wie bei anderen bekannten Resistsystemen, welche nach dem Prinzip der saurekatalytischen Spaltung arbeiten - der sogenannte Standzeit-Effekt festgestellt. Wenn nämlich die Zeitspanne ("delay time") zwischen der Belichtung und der Temperaturbehandlung (PEB) einen bestimmten Wert übersteigt, dann treten deutliche Abweichungen zwischen der nominalen Strukturdimension (Strukturgröße auf der Maske) und der abgebildeten Struktur (Strukturgröße im Resist nach der Entwicklung) auf. Je länger diese Zeitspanne ist, um so größer ist die Abweichung. Ab einem bestimmten Wert für die Zeitspanne, bei anhydridgruppenhaltigen Resists der vorstehend genannten Art beispielsweise ca. 30 min, sind nach der Entwicklung kaum noch Strukturen erkennbar. Die tolerable Zeitspanne beträgt bei diesen Resists ca. 5 bis 10 min. Eine derartige Zeitspanne kann aus produktionstechnischen Gründen jedoch nicht akzeptiert werden.

Das geschilderte Problem ist allgemein bekannt und wird auf basische Kontaminationen in der Luft zurückgeführt, die während der Standzeit die photochemisch erzeugte starke Säure desaktivieren. Deshalb wurde bereits vorgeschlagen, dieses Problem durch Filtration der Luft mittels Aktivkohle zu lösen (siehe: "Proc. SPIE", Vol. 1466 (1991), Seiten 2 bis 12). Dies erfordert aber hohe Investitionen.

Auch durch andere Maßnahmen, beispielsweise durch Zusatz von Additiven, konnte der Standzeiteffekt nicht entscheidend abgeschwächt werden (siehe: "Proc. SPIE", Vol. 1466 (1991), Seiten 13 bis 25). Eine Verlängerung der Standzeit ist zwar durch Aufbringen einer zusätzlichen Schicht möglich, aber nur im geringen Ausmaß. Außerdem stellt diese Maßnahme einen zusätzlichen Prozeßschritt dar, was aber in der Produktion unerwünscht ist, weil es zu Ausbeuteverlusten führt.

Aufgabe der Erfindung ist es, ein - nach dem Prinzip der saurekatalytischen Spaltung arbeitendes - Verfahren zur photolithographischen Strukturerzeugung anzugeben, mit dem - bei Resistsystemen der eingangs genannten Art - das Standzeitproblem ohne zusätzliche Prozeßschritte bzw. Investitionen gelöst werden kann, d.h. die Standzeit zwischen Belichtung und Temperaturbehandlung (von einem Wert von ca. 10 min) auf ein produktionstechnisch akzeptables Niveau erhöht wird.

Dies wird erfindungsgemäß dadurch erreicht,
- daß auf ein Substrat eine Photoresistschicht aufgebracht wird, bestehend aus
   einem Carbonsäureanhydridgruppen und tert.-Butylester- oder tert.-Butoxycarbonyloxygruppen enthaltenden Polymer, einer photoaktiven Komponente in Form eines Esters einer Naphthochinondiazid-4-sulfonsäure der Struktur 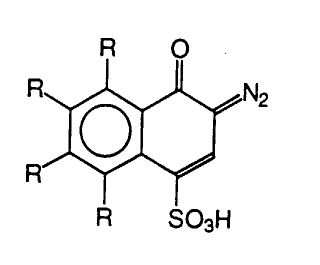 mit einer aromatischen oder aliphatisch-aromatischen Hydroxyverbindung, wobei die Reste R - unabhängig voneinander - Wasserstoff, Alkyl, Halogenalkyl, Alkoxy, Phenyl, Halogenphenyl, Phenoxy oder Halogen bedeuten, und einem geeigneten Lösungsmittel,
- daß die Photoresistschicht getrocknet wird,
- daß die Photoresistschicht bildmäßig belichtet wird,
- daß die belichtete Photoresistschicht einer Temperaturbehandlung im Bereich zwischen 120 und 150°C für die Dauer von 100 bis 600 s ausgesetzt wird,
- daß die derart behandelte Photoresistschicht einer Flüssigsilylierung unterworfen wird,
- und daß die silylierte Photoresistschicht in einem anisotropen Sauerstoffplasma trocken entwickelt wird.

Dem Verfahren nach der Erfindung liegt ein lagerstabiler trockenentwickelbarer Einlagenresist, d.h. ein Negativresist, auf der Basis eines Polymers zugrunde, das - neben Anhydridgruppen - tert.-Butylester- oder tert.-Butoxycarbonyloxygruppen besitzt. Ein derartiger Resist hat den Vorteil, daß er nicht nur im tiefen UV-Bereich (DUV), sondern auch im nahen UV-Bereich (NUV) wirksam ist.

Die photoaktive Komponente des Resists ist ein Ester aus einer Naphthochinondiazid-4-sulfonsäure und einer Hydroxyverbindung. Derartige photoaktive Komponenten sind an sich zwar bekannt (siehe dazu: "Methods and Materials in Microelectronic Technology", Plenum Press, New York (1984), Seiten 190 bis 193). Bei der Erfindung ist jedoch die gute Strukturierbarkeit des eine derartige photoaktive Komponente enthaltenden Resists überraschend. Bei der photolithographischen Strukturerzeugung sind nämlich bei tert.-butylesterhaltigen Basispolymeren in der Regel sehr starke Säurebildner erforderlich.

Beim Verfahren nach der Erfindung ist wesentlich, daß die Temperaturbehandlung (PEB) relativ lange dauert, nämlich ≥ 100 s, d.h. zwischen 100 und 600 s, und die PEB-Temperatur relativ hoch ist, nämlich 120 bis 150°C. Bei diesem Verfahren ergibt sich eine Verlängerung der Standzeit bis zu 16 h und mehr. Das Standzeitproblem wird dabei gelöst, ohne daß neue Verfahrensschritte bzw. neue Materialien erforderlich sind und ohne die Notwendigkeit von neuen Investitionen.

Im Vergleich zu gängigen Resists ist bei der Erfindung der Anteil an photoaktiver Komponente deutlich höher. Dieser Anteil beträgt vorteilhaft 20 bis 40 Masse-%, vorzugsweise 25 bis 35 Masse-%, bezogen auf den trockenen Photoresist, d.h. die lösungsmittelfreie Resistzusammensetzung. Vorteilhaft kann die photoaktive Komponente auch ein Gemisch aus einem Ester der genannten Art und einer Oniumverbindung sein. Derartige Verbindungen, die auch als Crivellosalze bezeichnet werden, sind beispielsweise Diphenyljodonium-trifluormethansulfonat (DPIT) und Triphenylsulfonium-trifluormethansulfonat (TPST). Im Ester der photoaktiven Komponente dient als Hydroxyverbindung vorzugsweise 2,3,4-Trihydroxybenzophenon oder Bisphenol A.

Beim Verfahren nach der Erfindung werden vorzugsweise solche Polymere eingesetzt, deren Carbonsäureanhydridgruppen sich von Maleinsäureanhydrid ableiten. Eine andere Verbindung dieser Art ist beispielsweise Itaconsäureanhydrid. Den Carbonsäure-tert.-butylestergruppen liegt vorzugsweise Acrylsäure-, Methacrylsäure-, Vinylbenzoesäure- oder Zimtsaure-tert.-butylester zugrunde, den tert.-Butoxycarbonyloxygruppen vorzugsweise tert.-Butoxycarbonyloxystyrol oder -maleinimid.

Als Lösungsmittel dienen an sich bekannte Resistlösungsmittel. Wichtig für die Auswahl des Lösungsmittels ist allein das Erfordernis, daß sowohl die Polymerkomponente als auch der Photoinitiator, d.h. die photoaktive Komponente, gelöst werden muß. Außerdem müssen - mit den bekannten Beschichtungsverfahren - fehlerfreie Resistschichten auf den Substraten gebildet werden, beispielsweise auf Siliciumwafern oder auf mit einem Bottomresist beschichteten Wafern. Vorzugsweise ist das Lösungsmittel Methoxypropylacetat, Cyclohexanon oder ein Ethylenglykol- bzw. Diethylenglykolether, gegebenenfalls im Gemisch mit Dibenzylether.

Durch die Flüssigsilylierung wird beim Verfahren nach der Erfindung eine Ätzresistenz gegen Trockenentwicklung im Sauerstoffplasma bewirkt. Dazu wird die Resistschicht mit einer polaren, protischen Silylierungslösung behandelt.Als Silylierungsagens dienen im allgemeinen Siliciumverbindungen in Form von Aminosilanen oder Aminosiloxanen; diese Verbindungen können oligomerer Natur sein. Die polare, protische Silylierungslösung ist vorzugsweise eine wäßrig-organische Lösung des Silylierungsagens. Dabei wird das Silylierungsagens vorteilhaft in Gemischen von Wasser und Alkohol, insbesondere Ethanol und/oder Isopropanol, gelöst; daneben können beispielsweise auch rein alkoholische Lösungen zum Einsatz gelangen.

Anhand von Ausführungsbeispielen soll die Erfindung noch näher erläutert werden. Dabei finden folgende Ausgangsmaterialien bzw. Reagenzien Verwendung (MT = Masseteile):
- Basispolymer
   Terpolymer aus Zimtsäure-tert.-butylester, Maleinsäureanhydrid und Stilben, hergestellt durch radikalische Polymerisation der drei Monomere in Ethylacetat mit Azoisobuttersäurenitril als Initiator.
- Photoaktive Komponente (1)
   Triester von 2,3,4-Trihydroxybenzophenon mit Naphthochinondiazid-4-sulfonsäure.
- Photoaktive Komponente (2)
   Diphenyljodonium-trifluormethansulfonat (DPIT).
- Silylierungslösung (1)
   Waßrig-alkoholische Lösung, bestehend aus 2 MT Diaminosiloxan, 78 MT Isopropanol und 20 MT Wasser; vorzugsweise wird ein α,ω-aminofunktionelles Siloxan, insbesondere mit zwei endständigen Aminopropylgruppen und 2 bis 20 Siliciumatomen in der Kette, verwendet, beispielsweise das handelsübliche Produkt Tegomer A-Si 2120 (Fa. Goldschmidt).
- Silylierungslösung (2)
   Alkoholische Lösung, bestehend aus 1 MT Diaminosiloxan (Tegomer A-Si 2120) und 99 MT Ethanol.

### Beispiel 1

Auf einen Siliciumwafer wird ein Resist, bestehend aus 9 MT Basispolymer, 3 MT photoaktive Komponente (1), 79,2 MT Methoxypropylacetat und 8,8 MT Dibenzylether, aufgeschleudert und 90 s bei 90°C auf einer Heizplatte getrocknet; die Schichtdicke des Resists beträgt 0,52 µm. Der Resist wird dann durch eine Maske mit 12 mJ/cm² kontaktbelichtet (Gerät MJB 3, Fa. Karl Süss; λ = 250 nm) und unmittelbar danach 120 s bei 135°C auf der Heizplatte getempert (PEB). Anschließend wird der Resist bei Raumtemperatur und Normaldruck, d.h. Raumklima, 45 s mit der Silylierungslösung (1) behandelt, dann 30 s mit Isopropanol gespült und danach 90 s bei 90°C auf der Heizplatte getrocknet. Nach dem Trocknen wird der Wafer in eine Plasmaätzanlage (Typ MIE 720, Fa. Material Research Corporation) gebracht und der Resist zunächst mit einem Plasma geätzt, das Sauerstoff (Gasfluß: 80 sccm) und Tetrafluormethan (Gasfluß: 9 sccm) enthält; der gesamte Gasdruck beträgt 1,067 Pa (8 mTorr), die Biasspannung 40 V. Anschließend wird in reinem Sauerstoffplasma geätzt (Gasdruck: 0,267 Pa (2 mTorr); Biasspannung: 50 V). Es werden negative Strukturen mit senkrechten Flanken und einem Steg/Graben-Verhältnis von 1:1 erhalten.

### Beispiel 2

Es wird wie in Beispiel 1 vorgegangen, der Wafer wird jedoch zwischen der Belichtung und der Temperung 16 h in einer Waferhorde offen im Prozeßraum liegen gelassen. Nach dem Ätzen werden ebenfalls negative Strukturen mit senkrechten Flanken und einem Steg/Graben-Verhältnis von 1:1 erhalten. Mikroskopische Untersuchungen zeigen, daß Strukturen gleicher Nominalbreite auf den geätzten Wafern nach Beispiel 1 und Beispiel 2 die gleiche Breite haben.

### Beispiel 3 (Vergleichsversuch)

Auf einen Siliciumwafer wird ein Resist, bestehend aus 11,1 MT Basispolymer, 0,9 MT photoaktive Komponente (2), 79,2 MT Methoxypropylacetat und 8,8 MT Dibenzylether, aufgeschleudert und 90 s bei 90°C auf einer Heizplatte getrocknet; die Schichtdicke des Resists beträgt 0,58 µm. Der Resist wird dann durch eine Maske mit 12 mJ/cm² kontaktbelichtet (Gerät MJB 3, Fa. Karl Süss; λ = 250 nm) und unmittelbar danach 60 s bei 100°C auf der Heizplatte getempert (PEB). Anschließend wird der Resist bei Raumtemperatur und Normaldruck, d.h. Raumklima, 20 s mit der Silylierungslösung (2) behandelt, dann 20 s mit Isopropanol gespült und danach 90 s bei 90°C auf der Heizplatte getrocknet. Nach dem Trocknen wird der Resist in einer Plasmaätzanlage wie in Beispiel 1 geätzt. Es werden negative Strukturen mit senkrechten Flanken und einem Steg/Graben-Verhältnis von 1:1 erhalten.

### Beispiel 4 (Vergleichsversuch)

Es wird wie in Beispiel 3 vorgegangen, der Wafer wird jedoch zwischen der Belichtung und der Temperung 1 h in einer Waferhorde offen im Prozeßraum liegen gelassen. Nach dem Ätzen kann keine eindeutige Strukturierung festgestellt werden, d.h. hierbei tritt das Standzeitproblem auf.

## Patentansprüche

1. Verfahren zur photolithographischen Strukturerzeugung im Submikron-Bereich, **dadurch gekennzeichnet,**
- daß auf ein Substrat eine Photoresistschicht aufgebracht wird, bestehend aus
einem Carbonsäureanhydridgruppen und tert.-Butylester- oder tert.-Butoxycarbonyloxygruppen enthaltenden Polymer, einer photoaktiven Komponente in Form eines Esters einer Naphthochinondiazid-4-sulfonsäure der Struktur 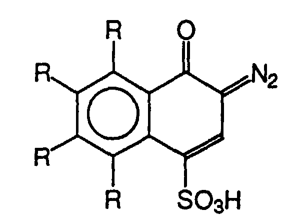 mit einer aromatischen oder aliphatisch-aromatischen Hydroxyverbindung, wobei die Reste R - unabhängig voneinander - Wasserstoff, Alkyl, Halogenalkyl, Alkoxy, Phenyl, Halogenphenyl, Phenoxy oder Halogen bedeuten, und einem geeigneten Lösungsmittel,
- daß die Photoresistschicht getrocknet wird,
- daß die Photoresistschicht bildmäßig belichtet wird,
- daß die belichtete Photoresistschicht einer Temperaturbehandlung im Bereich zwischen 120 und 150°C für die Dauer von 100 bis 600 s ausgesetzt wird,
- daß die derart behandelte Photoresistschicht einer Flüssigsilylierung unterworfen wird,
- und daß die silylierte Photoresistschicht in einem anisotropen Sauerstoffplasma trocken entwickelt wird.

2. Verfahren nach Anspruch 1, **dadurch gekennzeichnet,** daß die Hydroxyverbindung 2,3,4-Trihydroxybenzophenon oder Bisphenol A ist.

3. Verfahren nach Anspruch 1 oder 2, **dadurch gekennzeichnet,** daß der Anteil des Photoresists an photoaktiver Komponente 20 bis 40 Masse-% beträgt, vorzugsweise 25 bis 35 Masse-%.

4. Verfahren nach einem der Ansprüche 1 bis 3, **dadurch gekennzeichnet,** daß der photoaktiven Komponente eine Oniumverbindung zugesetzt wird.

5. Verfahren nach einem oder mehreren der Ansprüche 1 bis 4, **dadurch gekennzeichnet,** daß die Flüssigsilylierung mit einer polaren, protischen Silylierungslösung erfolgt.

6. Verfahren nach Anspruch 5, **dadurch gekennzeichnet,** daß als Silylierungslösung eine Lösung eines Aminosiloxans in einem Gemisch von Wasser und Alkohol, insbesondere Ethanol und/oder Isopropanol, verwendet wird.

7. Verfahren nach einem oder mehreren der Ansprüche 1 bis 6, **dadurch gekennzeichnet,** daß ein Polymer verwendet wird, dessen Carbonsäureanhydridgruppen Maleinsäureanhydrid zugrunde liegt.

8. Verfahren nach einem oder mehreren der Ansprüche 1 bis 7, **dadurch gekennzeichnet ,** daß ein Polymer verwendet wird, dessen tert.-Butylestergruppen Acrylsäure-, Methacrylsäure-, Vinylbenzoesäure- oder Zimtsäure-tert.-butylester zugrunde liegt.

9. Verfahren nach Anspruch 7 oder 8, **dadurch gekennzeichnet ,** daß ein Terpolymer aus Maleinsäureanhydrid, Zimtsäure-tert.-butylester und Stilben verwendet wird.

10. Verfahren nach einem oder mehreren der Ansprüche 1 bis 7, **dadurch gekennzeichnet,** daß ein Polymer verwendet wird, dessen tert.-Butoxycarbonyloxygruppen tert.-Butoxycarbonyloxystyrol oder -maleinimid zugrunde liegt.

## Claims

1. Method for producing photolithographic structures in the submicron range, characterised
- in that a photoresist layer is applied to a substrate, the photoresist layer consisting of a polymer containing carboxylic acid anhydride groups and tert. butyl ester or tert. butoxycarbonyloxy groups,
a photoactive component in the form of an ester of a naphthoquinonediazide-4-sulphonic acid of the structure 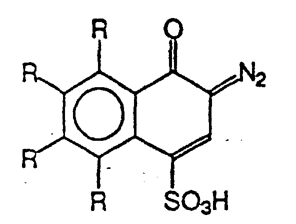 with an aromatic or aliphitic-aromatic hydroxy compound, the residues R signifying - independently of one another - hydrogen, alkyl, halogen alkyl, alkoxy, phenyl, halogen phenyl, phenoxy or halogen, and a suitable solvent;
- in that the photoresist layer is dried;
- in that the photoresist layer is exposed patternwise;
- in that the exposed photoresist layer is subjected to heat treatment in the range between 120 and 150°C for a period of 100 to 600 seconds;
- in that the photoresist layer treated in this way is subjected to liquid silylation;
- and in that the silylated photoresist layer is dry-developed in an anisotropic oxygen plasma.

2. Method according to claim 1, characterised in that the hydroxy compound is 2,3,4-trihydroxybenzophenone or bisphenol A.

3. Method according to claim 1 or 2,
characterised in that the proportion of the photoresist that is constituted by the photoactive component amounts to 20 to 40% by mass, preferably 25 to 35% by mass.

4. Method according to one of claims 1 to 3, characterised in that an onium compound is added to the photoactive component.

5. Method according to one or more of claims 1 to 4, characterised in that the liquid silylation takes place with a polar, protic silylation solution.

6. Method according to claim 5, characterised in that a solution of an aminosiloxane in a mixture of water and alcohol, in particular ethanol and/or isopropanol, is used as the silylation solution.

7. Method according to one or more of claims 1 to 6, characterised in that a polymer is used, the carboxylic acid anhydride groups of which are based on maleic anhydride.

8. Method according to one or more of claims 1 to 7, characterised in that a polymer is used, the tert. butyl ester groups of which are based on acrylic acid-, methacrylic acid-, vinyl benzoic acid- or cinnamic acid-tert. butyl ester.

9. Method according to claim 7 or 8,
characterised in that a terpolymer of maleic anhydride, cinnamic acid tert. butyl ester and stilbene is used.

10. Method according to one or more of claims 1 to 7, characterised in that a polymer is used, the tert. butoxycarbonyloxy groups of which are based on tert. butoxycarbonyloxystyrene or -maleinimide.

## Revendications

1. Procédé pour la formation d'une structure photolithographique dans le domaine du sous-micron, caractérisé
- en ce qu'on applique sur un substrat une couche de photoréserve constituée
par un polymère contenant des groupes d'anhydrides d'acides carboxyliques et des groupes d'esters tert.-butyliques ou des groupes tert.-butoxycarbonyloxy,
par un composant photoactif sous la forme d'un ester d'un acide naphtoquinonediazide-4-sulfonique répondant à la formule 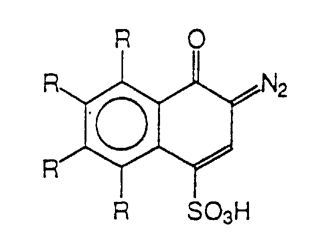 comprenant un composé hydroxylé aromatique ou aliphatique-aromatique, les radicaux R représentant - indépendamment l'un de l'autre - un atome d'hydrogène, un groupe alkyle, un groupe halogénalkyle, un groupe alcoxy, un groupe phényle, un groupe halogénophényle, un groupe phénoxy ou un atome d'halogène, et par un solvant approprié,
- en ce qu'on sèche la couche de photoréserve,
- en ce qu'on expose en forme d'image la couche de photoréserve,
- en ce qu'on soumet la couche de photoréserve exposée à un traitement thermique dans la plage de températures entre 120 et 150°C pendant un laps de temps de 100 à 600 secondes,
- en ce qu'on soumet la couche de photoréserve ainsi traitée à une silylation en phase liquide, et
- en ce qu'on développe à l'état sec la couche de photoréserve silylée dans un plasma d'oxygène anisotrope.

2. Procédé selon la revendication 1, caractérisé en ce que le composé hydroxylé est la 2,3,4-trihydroxybenzophénone ou le Bisphénol A.

3. Procédé selon la revendication 1 ou 2, caractérisé en ce que la fraction du composant photoactif dans la photoréserve s'élève de 20 à 40% en masse, de préférence de 25 à 35% en masse.

4. Procédé selon l'une quelconque des revendications 1 à 3, caractérisé en ce qu'on ajoute au composant photoactif un composé d'onium.

5. Procédé selon une ou plusieurs des revendications 1 à 4, caractérisé en ce que la silylation en phase liquide a lieu avec une solution de silylation protique polaire.

6. Procédé selon la revendication 5, caractérisé en ce qu'on utilise, à titre de solution de silylation, une solution d'un aminosiloxane dans un mélange d'eau et d'alcool, en particulier l'éthanol et/ou l'isopropanol.

7. Procédé selon une ou plusieurs des revendications 1 à 6, caractérisé en ce qu'on utilise un polymère dont les groupes d'anhydrides d'acides carboxyliques sont à base d'anhydride maléique.

8. Procédé selon une ou plusieurs des revendications 1 à 7, caractérisé en ce qu'on utilise un polymère dont les groupes d'esters tert.-butyliques sont à base d'esters tert.-butyliques d'acide acrylique, d'acide méthacrylique, d'acide vinylbenzoïque ou de l'acide cinnamique.

9. Procédé selon la revendication 7 ou 8, caractérisé en ce qu'on utilise un terpolymère d'anhydride maléique, d'ester tert.-butylique de l'acide cinnamique et de stilbène.

10. Procédé selon une ou plusieurs des revendications 1 à 7, caractérisé en ce qu'on utilise un polymère dont les groupes tert.-butoxycarbonyloxy sont à base de tert.-butoxycarbonyloxystyrène ou de tert.-butoxycarbonyloxymaléinimide.
